## Europäisches Patentamt
## European Patent Office
## Office européen des brevets

(19)

(11) Veröffentlichungsnummer: **0 080 479**
**B1**

(12)

# EUROPÄISCHE PATENTSCHRIFT

(45) Veröffentlichungstag der Patentschrift:
**27.11.85**

(51) Int. Cl.⁴: **G 03 F 7/20**, G 03 B 27/18

(21) Anmeldenummer: **82901716.9**

(22) Anmeldetag: **02.06.82**

(86) Internationale Anmeldenummer:
**PCT/DE 82/00118**

(87) Internationale Veröffentlichungsnummer:
**WO 82/04333 (09.12.82 Gazette 82/29)**

(54) Belichtungsgerät.

(30) Priorität: **06.06.81 DE 3122707**

(43) Veröffentlichungstag der Anmeldung:
**08.06.83 Patentblatt 83/23**

(45) Bekanntmachung des Hinweises auf die Patenterteilung:
**27.11.85 Patentblatt 85/48**

(84) Benannte Vertragsstaaten:
**AT BE CH FR GB LI NL SE**

(56) Entgegenhaltungen:
**CH - A - 133 225**
**DE - A - 2 719 716**
**DE - A - 2 916 786**
**DE - A - 2 928 320**
**DE - A - 3 014 840**
**DE - A - 3 030 400**
**DE - B - 2 549 989**
**FR - A - 2 476 335**
**US - A - 3 357 335**

(73) Patentinhaber: **THEIMER, Siegfried, Rohler Strasse 12, D-6484 Obersotzbach (DE)**

(72) Erfinder: **THEIMER, Siegfried, Rohler Strasse 12, D-6484 Obersotzbach (DE)**

(74) Vertreter: **Nix, Frank Arnold, Dr., Kröckelbergstrasse 15, D-6200 Wiesbaden (DE)**

## Beschreibung

Die vorliegende Erfindung bezieht sich auf ein Belichtungsgerät für die reprographische Technik, wie es gebraucht wird, um ein Fotomaterial durch eine Kopiervorlage hindurch zu belichten. Das Fotomaterial ist gewöhnlich ein Film, eine Offsetdruckplatte oder eine fotopolymere Druckplatte, und die Kopiervorlage ist gewöhnlich ein entwickelter Film. Fotomaterial und Kopiervorlage stellen zusammen die Kopierpartner dar.

Bei der Belichtung von solchen Fotomaterialien durch eine Kopiervorlage hindurch hängt die Qualität des Kopierergebnisses entscheidend ab von einem satten, völlig abstandsfreien Anliegen der Kopierpartner aneinander. Um dies zu gewährleisten, werden gewöhnlich besondere Massnahmen ergriffen, um das Fotomaterial auf der gesamten Fläche zuverlässig an die Kopiervorlage anzudrücken.

Am meisten verbreitet ist hierzu die Verwendung einer biegsamen Matte, insbesondere einer Gummimatte, die nach Zwischenlegen der Kopierpartner mit einer Glasplatte zusammengedrückt werden kann, durch welche die Belichtung erfolgt. Beim Zusammendrücken von Gummimatte und Glasplatte kommt es zur dichtenden Anlage eines die Matte umgrenzenden Dichtungswulsts. In der Matte ist wenigstens eine an eine Unterdruckquelle anschliessbare Öffnung vorhanden, und nach Erzeugung eines Unterdrucks im Raum zwischen Glasplatte und Matte wird die Matte und die zwischenliegenden Kopierpartner (Kopiervorlage und Fotomaterial) an die Glasplatte angesogen bzw. vom auf die andere Oberfläche der Matte wirkenden grösseren atmosphärischen Druck gegen die Glasplatte gedrückt.

Ein immer wieder auftauchendes Problem ist die Vermeidung von sogenannten Hohlkopien. Hierunter versteht man Kopien mit unscharfen Bereichen, die dadurch zustandekommen, dass trotz Bemühungen um einen ganzflächigen innigen Kontakt zwischen den Kopierpartnern noch Bereiche vorhanden sind, auf denen ein Abstand zwischen Kopiervorlage und Fotomaterial verblieben ist. Im Bereich solcher Lufttaschen gehen wegen der Streulichtbeleuchtung feine Linien und Rasterpunkte sowie die Vorlagentreue der Kopie verloren.

Es gibt vielfältige Versuche, diesem Übelstand abzuhelfen. Die der vorliegenden Erfindung nächstkommende Lösung ist in der DE-B-2 549 989 oder der FR-A-2 476 335 beschrieben. Diese zeigen ein Belichtungsgerät zur Belichtung von Fotomaterial durch eine Kopiervorlage hindurch mit einer Glasplatte und einer Gummimatte, die gegeneinander drückbar angeordnet sind und zwischen denen durch Anschluss an eine Vakuumquelle ein Unterdruck herstellbar ist, wobei die Kopierpartner zwischen die Glasplatte und die dieser zugewandte Vorderseite der Gummimatte eingelegt werden und die Belichtung durch die Glasplatte hindurch erfolgt, sowie mit einer über die Rückseite der Gummimatte zum Zwecke des Glattstreichens abrollbaren Andrückwalze.

Bei dieser bekannten Ausbildung, von der die vorliegende Erfindung ausgeht, ist die Glattstreichwalze in einem verschiebbaren Kasten zusammen mit einer Wickelwalze angeordnet, wobei sich bei der Verschiebung des Kastens längs der Glasplatte die Gummimatte rolloartig von der Wickelwalze abwickelt und über die Glasplatte mit den Kopierpartnern legt. Es kommt dabei also nur zu einem einzigen Glattstreichvorgang durch die der Wickelwalze nachfolgenden Glattstreichwalze.

Aus der US-A-2 584 401 ist eine weitere Ausbildung mit zwei Glattstreichwalzen bekannt, deren jede aber nur die halbe Fläche glattstreicht, so dass auch hier jede Oberflächenstelle nur einen Glattstreichvorgang erfährt.

Hinzu kommt bei dieser bekannten Ausbildung noch, dass die beiden elastischen Glattstreichwalzen auf einem das Kopiermaterial niederhaltenden Andrückrahmen abrollen. Wegen der endlichen Dicke des Rahmens und der Elastizität der Rolle ist zumindest in Rahmennähe kein vollständiges Ausstreichen der Luft gewährleistet.

Nachteilig ist also beim Stand der Technik, dass nur eine Andrückwalze nur einmalig über die Rückseite der Gummimatte abgerollt wird, was das vollständige Ausstreichen eventueller Lufttaschen nicht zuverlässig gewährleisten kann.

Der Erfindung liegt demgemäss die Aufgabe zugrunde, eine Andrückvorrichtung der gattungsgemässen Ausbildung so zu verbessern, dass ein vollständiges Glattstreichen und Entfernen von Lufttaschen zuverlässig gelingt.

Die Lösung der gestellten Aufgabe gelingt erfindungsgemäss mittels eines auf der Rückseite der Gummimatte angeordneten Kettentriebs mit zwei über je zwei Antriebskettenräder und Umlenkkettenräder umlaufenden endlosen Ketten, auf bzw. zwischen denen in gleichmässiger Verteilung längs der Ketten eine Mehrzahl von Andrückwalzen gelagert ist.

Durch diese erfindungsgemässe Konstruktion kann eine Vielzahl von Glattstreichvorgängen verwirklicht werden, die in gleicher Richtung zu einem Rand hin verlaufen. Dies gewährleistet ein zuverlässiges mechanisches Ausquetschen der Lufttaschen zwischen den zwischen der Gummimatte und der Glasplatte liegenden Kopierpartnern, und zwar auch, wenn die beteiligten Oberflächen leicht kleben. Dabei kann mit geringerem Unterdruck gearbeitet werden, was bei empfindlichen Filmen den Vorteil hat, dass sich Druckstellen nicht abbilden, die z.B. von der strukturierten Gummioberfläche herrühren.

Vorteilhafterweise ist die Gummimatte in einen Rahmen eingespannt, in dem die zwei endlosen Ketten parallel zu den Längswangen des Rahmens verlaufen, wobei die Andrückwalzen sich in Querrichtung zwischen diesen erstrecken und die der Gummimatte zugewandten Kettentrume über ihre Erstreckung von einer Andrückschiene gestützt sind. Dabei können auch die Achsenden der Andrückwalzen in den Ketten quer zur Erstreckung derselben beweglich und federbeaufschlagt gelagert sein, so dass sie bei ihrer Bewegung über die Gummimatte gleichmässig an diese angedrückt sind.

Um ein etwa konstantes Andrücken der Andrückwalzen während des Durchlaufens des Arbeitsabschnitts zu erzielen, können auch die Andrückschienen als flexible Leisten ausgebildet sein und in kurzen Abständen durch Federn oder dergleichen in Richtung zur Gummimatte beaufschlagt sein, oder jede Andrückschiene kann sich zusammensetzen aus einer Vielzahl von aufeinanderfolgenden Abschnitten, deren jeder individuell das arbeitende Kettentrum zur Gummimatte hin drückt.

Wenn die Abstände zwischen den Andrückwalzen zu gering sind, kann es sein, dass diese sich in ihrer Wirkung gegenseitig behindern, indem eine vor einer Andrückwalze hergeschobene Lufttasche am Entweichen durch die vorauslaufende Walze behindert wird. Es ist dann zweckmässig, wenn zwischen jeweils zwei benachbarten Walzen wenigstens eine Welle angeordnet ist, auf der in Abständen Andrückscheiben sitzen. Diese Andrückscheibenwelle erzeugt dann nur laufende Andrückpunkte bzw. eine unterbrochene Andrücklinie, so dass zwischen den Kontaktstellen die Möglichkeit des Entweichens von Lufteinschlüssen bleibt.

Wenn mehrere Andrückscheibenwellen zwischen benachbarten Andrückwalzen angeordnet werden, so ist es zweckmässig, deren Andrückscheiben in Querrichtung gegeneinander versetzt anzuordnen.

Wenn ein Ausstreichen eventueller Lufteinschlüsse mehrfach in der gleichen Richtung erfolgt ist, kann es zweckmässig sein, den Antriebsmotor der Kettentriebe umzusteuern und die Glattstreichvorrichtung in der Gegenrichtung laufen zu lassen. Hierdurch können eventuell doch noch vorhandene Verklebungen zwischen den beteiligten Oberflächen unter Umständen besser gelöst werden.

Die Erfindung ist anwendbar sowohl bei Belichtungsgeräten mit Aufwärtsbelichtung als auch bei Belichtungsgeräten mit von oben her erfolgender Belichtung.

Bei Belichtungsgeräten mit Aufwärtsbelichtung befindet sich der die nach oben gerichtete Lichtstrahlung erzeugende Brenner in einem Standgehäuse, dessen obere Abdeckung die ortsfeste Glasplatte darstellt; in diesem Falle ist dann zweckmässigerweise die Gummimatte mit der gesamten auf sie einwirkenden Glattstreichvorrichtung aus Motor, Kettentrieben und Andrückwalzen in einem Rahmen angeordnet, der hoch- und herunterschwenkbar am Standgehäuse angelenkt ist.

Bei Belichtungsgeräten mit von oben her erfolgender Belichtung ist die Gummimatte ortsfest angeordnet, und die Glasplatte ist hoch- und herunterschwenkbar am Gehäuse angelenkt. In diesem Falle ist dann die Glattstreichvorrichtung zweckmässigerweise unterhalb der Gummimatte im Ghäuse angeordnet.

Es ist schliesslich vorteilhaft, eine Programmsteuerung in der Weise anzuwenden, dass das mechanische Glattstreichen stattfindet, während oder nachdem ein zunächst nur schwächeres Vorvakuum gezogen wird, wonach die Glattstreichvorrichtung stillgelegt wird und das endgültige Vollvakuum gezogen wird.

Die Erfindung wird nachfolgend durch die Beschreibung eines Ausführungsbeispiels anhand der beigegebenen Zeichnungen weiter erläutert. Es zeigt:

Fig. 1 schematisch eine Querschnittsdarstellung des Belichtungsgeräts nach der Schnittlinie I-I in Fig. 2;

Fig. 2 die Draufsicht auf das Belichtungsgerät.

Bei der beispielsgemässen Ausführung des Belichtungsgeräts handelt es sich um ein solches für die nach oben erfolgende Belichtung, bei der ein (nicht gezeigter) Brenner in einem Standgehäuse 1 untergebracht ist und nach oben durch eine Glasplatte 2 strahlt, auf die die Kopierpartner 3 aufzulegen sind, nämlich zuerst die Kopiervorlage und hierauf das Fotomaterial.

Zum dichten Andrücken der Kopierpartner aneinander und an die Glasplatte kann auf diese eine Gummimatte 4 abgesenkt werden, die in einem Rahmen 5 eingespannt ist, welcher schwenkbar am Standgehäuse 1 angelenkt ist. Die Gummimatte 4 hat in üblicher Weise eine längs ihres Randes umlaufende Dichtlippe und in wenigstens einer Ecke eine Öffnung, an die eine Unterdruckquelle anschliessbar ist, um den Raum zwischen Glasplatte und Gummimatte zu evakuieren.

Auf der von der Glasplatte 2 abgewandten Rückseite der Gummimatte 4 ist im Rahmen 5 eine gesamtheitlich mit 6 bezeichnete Glattstreichvorrichtung eingebaut. Diese besteht aus einem Kettentrieb aus zwei endlosen Ketten 7, deren jede dicht neben einer Längswange 8 des Rahmens 5 verläuft und dabei jeweils ein Antriebskettenrad 9 und ein Umlenkkettenrad 10 umschlingt. Die Antriebskettenräder 9 sitzen auf einer Antriebswelle 11, die von einem Motor 20 in Drehung versetzt wird und jedes Umlenkkettenrad 10 sitzt auf einem Achsstummel 21.

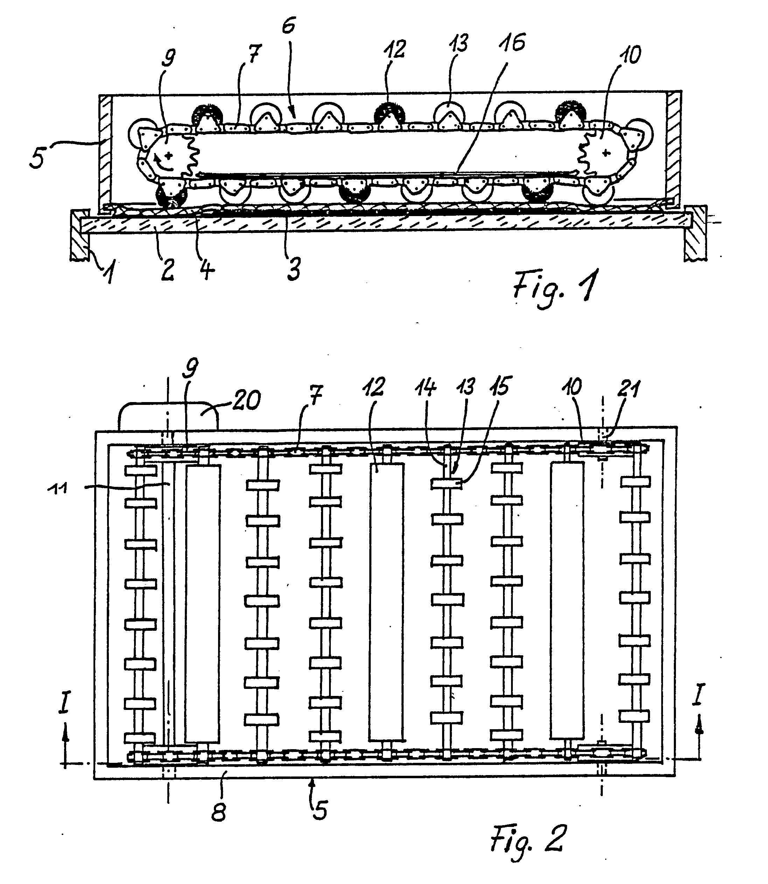

In regelmässigen Abständen sind Kettenlaschen wie in Fig. 1 ersichtlich so ausgebildet, dass in ihnen drehbar ein Achsende gelagert werden kann. Auf diese Weise erstrecken sich in Querrichtung zwischen den Ketten von diesen getragene Walzen 12, die eine Gummioberfläche besitzen und Scheibenwellen 13, die aus einer Achse 14 mit auf ihr in Abständen sitzenden Kreisscheiben 15 bestehen. Im Betrieb erzeugen die Andrückwalzen 12 eine längs der Gummimatte 4 wandernde Kontaktlinie und die Scheibenwellen in gleicher Weise wandernde Kontaktpunkte bzw. Kontaktlinienabschnitte.

Bei der dargestellten Ausführungsform sind zwischen jeweils zwei benachbarten Andruckwalzen 12 zwei Scheibenwellen 13 angeordnet, deren Scheiben 15 in Querrichtung zueinander versetzt sind.

Um die Andrückung der Andrückelemente 12 und 13 auf der gesamten Erstreckung längs der Gummimatte 4 sicherzustellen, sind (in Fig. 2 der Klarheit wegen nicht gezeigte) Andrückschienen 16 vorgesehen, die jedes der unteren Kettentrume nach unten in Richtung zur Gummimatte 4 drücken.

Um die sich am Rand der Kopierpartner ergebenden Höhendifferenzen der Gummimattenrückenfläche oder auch im Bereich der Kopierpartner, z.B. bei Montagen, auftretende unterschiedliche Dicken ausgleichen zu können, ist jede Andrückschiene leicht biegbar und elastisch ausgebildet und es ist auf geeignete Weise sichergestellt, dass sie auf ihrer ganzen Länge mit etwa gleicher Kraft pro Längenerstreckung auf das untere Kettentrum drückt. Dies kann z.B. sichergestellt werden durch in kurzen Abständen aufeinanderfolgende, die Andrückschiene nach unten beaufschlagende Druckfedern oder dadurch, dass jede der Andrückschienen in kurze, individuell nach unten federnde Abschnitte aufgeteilt ist, oder die Andrückelemente sind federnd in den Ketten gelagert.

Die Arbeit mit dem beschriebenen Belichtungsgerät verläuft wie folgt:

Die Kopierpartner 3 werden auf die Glasplatte 2 gelegt und der Rahmen 5 wird nach unten geschwenkt und in der abgesenkten Stellung verriegelt. Dann wird die Glattstreichvorrichtung 6 dadurch in Tätigkeit gesetzt, dass der Motor 20 eingeschaltet wird; gleichzeitig kann ein Vorvakuum gezogen werden.

In dieser Betriebsphase rollen die Andrückelemente 12 und 13 über die Rückenfläche der Gummimatte und streichen diese unter Andrückung an die Glasplatte mechanisch glatt, wobei evtl. Lufteinschlüsse in Längsrichtung ausgestrichen werden. Die den Andrückwalzen 12 vorauslaufenden Scheibenwellen 13 bereiteten die Andrückung in ununterbrochener Kontaktlinie durch die Andrückwalzen 12 vor, ohne zu verhindern, dass evtl. Lufttaschen auch nach vorn ausgequetscht werden können.

Bei etwas klebenden Oberflächen von Matte und Kopierpartnern kann es zweckmässig sein, nach einer gewissen Zeit den Motor 20 umzusteuern, so dass das Glattstreichen in der Gegenrichtung erfolgt. Es versteht sich, dass all dies automatisch erfolgen kann, z.B. durch eine Programmsteuerung des Motors, wie auch schon das Einschalten z.B. durch das Absenken des Rahmens 5 bewirkt werden kann.

Wenn evtl. Lufteinschlüsse zuverlässig beseitigt sind, wird die Glattstreichvorrichtung 6 angehalten und der Unterdruck zwischen Gummimatte und Glasplatte auf den vollen Vakuumwert erhöht. Danach erfolgt die Belichtung.

Vorstehend ist von einem wie üblich länglichen Rahmen 5 ausgegangen, bei dem die Ketten 7 sinnvollerweise parallel den Längswangen 8 verlaufen. Sollte der Rahmen einen quadratischen Grundriss haben, so ist es gleichgültig, in welcher Richtung das Glattstreichen erfolgt.

Ebenso versteht es sich, dass der Grundgedanke der Erfindung sich nicht ändert, wenn statt eines Belichtungsgeräts mit aufwärts gerichteter Lichtstrahlung ein solches Verwendung findet, bei dem die Gummimatte ortsfest die obere Fläche eines Standgehäuses darstellt und die Glasplatte auf die Gummimatte abgesenkt werden kann, wobei dann der Brenner oberhalb angeordnet ist und die Glasplatte von oben her beleuchtet. In diesem Falle ist dann die Glattstreichvorrichtung im Standgehäuse unterhalb der Matte angeordnet.

Schliesslich versteht es sich, dass für die einzelnen Elemente technische Äquivalente Verwendung finden können; z.B. dass die Platte 2 statt aus Glas aus einem anderen transparenten oder durchscheinenden Material bestehen kann und dass die Matte 4 statt aus Gummi aus einem anderen biegsamen Material bestehen kann.

**Patentansprüche**

1. Belichtungsgerät zur Belichtung von Fotomaterial durch eine Kopiervorlage hindurch mit einer Glasplatte (2) und einer Gummimatte (4), die gegeneinander drückbar angeordnet sind und zwischen denen durch Anschluss an eine Vakuumquelle ein Unterdruck herstellbar ist, wobei die Kopierpartner (3) zwischen die Glasplatte (2) und die dieser zugewandte Vorderseite der Gummimatte (4) eingelegt werden und die Belichtung durch die Glasplatte (2) hindurch erfolgt, sowie mit einer über die Rückseite der Gummimatte (4) zum Zwecke des Glattstreichens abrollbaren Andrückwalze, gekennzeichnet durch einen auf der Rückseite der Gummimatte (4) angeordneten Kettentrieb mit zwei endlosen Ketten (7), die über je zwei Antriebskettenräder (9) und Umlenkkettenräder (10) umlaufen und zwischen denen sich in gleichmässiger Verteilung längs der Ketten eine Mehrzahl von Andrückwalzen (12) erstreckt.

2. Belichtungsgerät nach Anspruch 1, gekennzeichnet durch einen Rahmen (5), in dem die Gummimatte (4) eingespannt ist und in dem die zwei endlosen Ketten (7) parallel zu den Längswangen (8) verlaufen, wobei die Andrückwalzen (12) sich in Querrichtung zwischen diesen erstrecken und die der Gummimatte zugewandten Kettentrume über ihre Erstreckung von einer Andrückschiene (16) gestützt sind.

3. Belichtungsgerät nach Anspruch 2, dadurch gekennzeichnet, dass die Achsenden der Andrückwalzen (12) in den Ketten (7) quer zur Erstreckung derselben beweglich und nach aussen federbeaufschlagt gelagert sind.

4. Belichtungsgerät nach Ansprüchen 2 oder 3, dadurch gekennzeichnet, dass jede Andrückschiene (16) als flexible Leiste ausgebildet ist und ihrerseits in kurzen Abständen durch Federn in Richtung zur Gummimatte beaufschlagt ist oder sich aus einer Vielzahl von aufeinanderfolgenden Abschnitten zusammensetzt, deren jeder individuell das arbeitende Kettentrum in Richtung zur Gummimatte andrückt.

5. Belichtungsgerät nach den vorhergehenden Ansprüchen, dadurch gekennzeichnet, dass die Oberfläche der Andrückwalzen (12) aus einer weichen Gummischicht besteht.

6. Belichtungsgerät nach einem oder mehreren der vorhergehenden Ansprüche, dadurch gekennzeichnet, dass zwischen jeweils zwei benachbarten Andrückwalzen (12) wenigstens eine Welle (13) angeordnet ist, auf der in Abständen Andrückscheiben (15) sitzen.

7. Belichtungsgerät nach Anspruch 6, gekennzeichnet durch wenigstens zwei zwischen benachbarten Andrückwalzen angeordnete Scheibenwellen (13), deren Scheiben (15) in Querrichtung gegeneinander versetzt sind.

8. Belichtungsgerät nach einem oder mehreren der vorhergehenden Ansprüche, gekennzeichnet durch einen umsteuerbaren Antriebsmotor (20) für die Antriebskettenräder (9).

9. Belichtungsgerät nach einem oder mehreren der vorhergehenden Ansprüche, dadurch gekennzeichnet, dass die Glasplatte (2) ortsfest in einem Standgehäuse (1) gehalten ist und der die Gummimatte (4) und die auf diese einwirkende Glattstreichvorrichtung (6) tragende Rahmen (5) schwenkbar am Standgehäuse angelenkt ist.

10. Belichtungsgerät nach einem oder mehreren der Ansprüche 1 bis 8, dadurch gekennzeichnet, dass die Gummimatte ortsfest in einem Standgehäuse gehalten ist und die Glattstreichvorrichtung unterhalb derselben angeordnet ist, und dass die Glasplatte auf die Gummimatte herabschwenkbar angelenkt ist, wobei die Belichtung von oben her erfolgt.

11. Belichtungsgerät nach den vorhergehenden Ansprüchen, gekennzeichnet durch eine Programmsteuerung in der Weise, dass nach dem Gegeneinanderdrücken von Gummimatte und Glasplatte zuerst ein Vorvakuum gezogen wird, danach die Glattstreichvorrichtung (6) in Tätigkeit gesetzt wird und schliesslich das volle Vakuum gezogen wird.

## Claims

1. Exposure device for exposing photographic material through a master, with a glass plate (2) and a rubber mat (4) which can be pressed one against the other and the space between which can be evacuated by connection to a vacuum source, and in which the copying partners (3) are inserted between the glass plate (2) and the front side of the rubber mat (4) facing said glass plate and the exposure is effected through the glass plate (2), and with a pressure roll arranged to be rolled over the rear side of the rubber mat (4) for flattening the same, characterized by a chain drive installed at the rear side of the rubber mat (4), possessing two endless chains (7) passing around two driving sprockets (9) and reversing sprockets (10), between which a plurality of pressure rolls (12) extend transversely at uniform intervals along the chains.

2. Exposure device according to claim 1, characterized by a frame (5) in which the rubber mat (4) is tautly mounted and in which the two endless chains (7) run parallel to the longitudinal sections (8), the pressure rolls (12) extending transversely between the same and the chain strands adjacent the rubber mat being supported over their extent by pressure rails (16).

3. Exposure device according to claim 2, characterized in that the shaft ends of the pressure rolls (12) are supported movably in a direction transverse to the extends of the chains (7) and resiliently forced to the outside .

4. Exposure device according to claims 2 or 3, characterized by each pressure rail (16) being in the form of a flexible strip which is forced towards the rubber mat by springs in short intervals, or consisting of a plurality of segments succeeding each other, each one pressing the working chain strand individually in the direction of the rubber mat.

5. Exposure device according to the preceding claims, characterized in that the surface of the pressure rolls (12) consists of a layer of soft rubber.

6. Exposure device according to one or several of the preceding claims, characterized in that between each two adjacent pressure rolls (12) there is provided at least one shaft (13), upon which pressure disks (15) are mounted in a spaced apart manner.

7. Exposure device according to claim 6, characterized in that between adjacent pressure rolls at least two disk shafts (13) are arranged, the disks (15) whereof are offset transversely with respect to each other.

8. Exposure device according to one or several of the preceding claims, characterized by a reversible drive motor (20) for the drive sprockets (9).

9. Exposure device according to one or several of the preceding claims, characterized in that the glass plate (2) is held stationary in a housing stand (1) and the frame (5) carrying the rubber mat (4) and the flattening device (6) acting upon the same is pivotally connected to the housing stand.

10. Exposure device according to one or several of claims 1 through 8, characterized in that the rubber mat is held stationary in a housing stand and the flattening device is arranged under the rubber mat, the glass plate being articulated so that it may be pivoted down onto the rubber mat, with the exposure being effected from above.

11. Exposure device according to the preceding claims, characterized by a programmed control so that after the bringing together the rubber mat and glass plate a prevacuum is established, after which the flattening device (6) is actuated, and finally a full vacuum is applied.

## Revendications

1. Appareil d'exposition de matériel photographique à travers un original ou exemplaire à copier comportant: une plaque de verre (2) et un mat de caoutchouc (4) qui peuvent être pressés l'un contre l'autre et entre lesquels on peut établir une dépression grâce à un raccordement à une source de vide, l'original et le support de la copie étant disposés entre le plaque de verre (2) et la face du mat de caoutchouc (4) tournée vers ladite plaque de verre et l'exposition étant effectuée à travers la plaque de verre (2), ainsi qu'un cylindre de pression roulant sur le dos du mat de caoutchouc (4) en vue de le lisser, caractérisé par un entraînement à chaînes agencé sur le dos du mat de caoutchouc (4) comportant deux chaînes sans fin (7) qui sont entraînées respectivement sur une roue dentée motrice (9) et une roue dentée de renvoi (10), et entre lesquels s'étendent plusieurs cylindres de pression (12) répartis uniformément sur la longueur des chaînes.

2. Appareil d'exposition selon la revendication 1 caractérisé par un cadre (5) dans lequel est serré le mat de caoutchouc (4) et dans lequel les deux chaînes sans fin (7) s'étendent parallèlement aux flancs longitudinaux (8), les cylindres de pression (12) s'étendant entre celles-ci selon une direction transversale, et les brins de chaîne tournés vers le mat de caoutchouc étant supportés, le long de leur parcours, par un rail de pression (16).

3. Appareil d'exposition selon la revendication 2 caractérisé en ce que les extrémités d'axe des cylindres de pression (12) sont logées de manière mobile et par l'intermédiaire d'un ressort dans les chaînes (7), transversalement par rapport à la disposition de celles-ci.

4. Appareil d'exposition selon les revendications 2 ou 3 caractérisé en ce que chaque rail de pression (16) se présente sous la forme d'un profilé flexible et comporte des ressorts, à intervalles courts, en direction du mat de caoutchouc, ou bien se compose d'une pluralité de segments successifs dont chacun applique individuellement le brin de chaîne qui travaille sur le mat de caoutchouc.

5. Appareil d'exposition selon les revendications précédentes caractérisé en ce que la surface des cylindres de pression (12) consiste en une couche mince de caoutchouc mou.

6. Appareil d'exposition selon l'une ou plusieurs des revendications précédentes caractérisé en ce qu'au moins un arbre (13) muni de disques de pression (15) à distance l'un de l'autre est agencé entre deux cylindres de pression (12) adjacents.

7. Appareil d'exposition selon la revendication 6 caractérisé par au moins deux arbres à disques (13) agencés entre des cylindres de pression adjacents, arbres à disques dont les disques (15) sont décalés l'un par rapport à l'autre, dans le direction transversale.

8. Appareil d'exposition selon l'une ou plusieurs des revendications précédentes caractérisé par un moteur d'entrainement inversable (20) pour les roues dentées motrices (9).

9. Appareil d'exposition selon l'une ou plusieurs des revendications précédentes caractérisé en ce que la plaque de verre (2) est maintenue de manière immobile dans un boîtier fixe (1) et en ce que le cadre (5) portant le mat de caoutchouc (4) ainsi que le dispositif de lissage (6) qui agit sur celui-ci est articulé de manière pivotable audit boîtier fixe (1).

10. Appareil d'exposition selon l'une ou plusieurs des revendications 1 à 8 caractérisé en ce que le mat de caoutchouc est maintenu de manière immobile dans un boîtier fixe, en ce que le dispositif de lissage est agencé en dessous de celui-ci et en ce que la plaque de verre est articulée de manière à pouvoir pivoter vers la mat de caoutchouc, l'exposition étant effectuée par le haut.

11. Appareil selon les revendications précédentes caractérisé par une commande à programme de telle sorte que, après l'application l'un contre l'autre du mat de caoutchouc et de la plaque de verre, on applique d'abord une dépression préalable, on met ensuite le dispositif de lissage (6) en marche et on applique finalement le vide à ses capacités maximales.

Fig. 1

Fig. 2